Europäisches Patentamt

European Patent Office

Office européen des brevets

(19)

(11) Publication number : **0 482 877 A1**

## (12) EUROPEAN PATENT APPLICATION

(21) Application number : 91309735.8

(22) Date of filing : 22.10.91

(51) Int. Cl.⁵ : **C23C 16/44, F24H 3/04**

(30) Priority : 22.10.90 US 601261

(43) Date of publication of application :
29.04.92 Bulletin 92/18

(84) Designated Contracting States :
DE FR GB IT NL

(71) Applicant : WATKINS-JOHNSON COMPANY
3333 Hillview Avenue
Palo Alto California 94304 (US)

(72) Inventor : Walker, Fred F.
Post Office Box 3011
Ben Lomond, California 95005 (US)
Inventor : Provancha, Kenneth M.
5498 Ball Drive
Soquel, California 95073 (US)
Inventor : Vaughan, Eric R.
231 Peyton Street
Santa Cruz, California 95060 (US)

(74) Representative : Flegg, Christopher Frederick
et al
Boult, Wade & Tennant 27 Furnival Street
London EC4A 1PQ (GB)

(54) **Heated fluid supply line.**

(57) A supply line for heating a fluid, such as a chemical vapor, includes a pair of spaced-apart, electrically-conductive fluid line segments (12,14). The first of these fluid line segments has a first inlet end (16) and a second outlet end (18). The second fluid line segment has a first inlet end (20) and a second outlet end (22). A fluid connection is provided between the second outlet end of the first fluid line segment and the first inlet end of the second fluid line segment. An electrical connection is provided for electrically connecting the second end of the first fluid line segment with the first end of the second fluid line segment. Similarly, an electrical connection is provided for electrically connecting the first end of the first fluid line segment with the second end of the second fluid line segment. An electrical voltage is applied between the first and second electrical connections to cause an electrical current to flow through the first and second fluid line segments and to thereby heat a fluid flowing through these fluid line segments.

FIG. — 1

EP 0 482 877 A1

Field of the Invention.

This invention relates to heaving systems for vapor-delivery lines which deliver heated chemical gases to reaction chambers for semiconductor processes.

Prior Art.

Manufacturing processes for fabricating semiconductor devices and integrated circuits require the use of chemicals in a vapor form, where the flow rate and the temperature of the chemical vapor must be precisely controlled. The chemical vapor is generated in a source such as a bubbler in which a carrier gas is bubbled through a liquid chemical source to provide a chemical vapor, which is mixed with the carrier gas. The lines for delivering chemical vapor from the source to a reaction chamber are required to be temperature-controlled to prevent condensation of the chemical vapor. Heating of the delivery lines is accomplished by using the delivery line, or pipe, itself as a distributed heating element, through which an electrical current is passed to generate heat in the walls of the delivery lines. Stainless steel is a suitable material for this type of application.

A delivery line is heated by having two spaced-apart electrical terminal connected to the delivery line and applying a suitable electrical current through the terminals and through the line. A major problem associated with heating of a delivery line section by an electrical current is that at least one end of the line section must be electrically isolated from the main part of the delivery line to confine the electrical current to the line section being heated. This requires use of an isolation coupling for the line section so that the line section is electrically isolated. In comparison with using welded stainless steel lines without couplers of any sort, isolation couplings have a number of problems associated with their use. These include breakage of glass or ceramic elements, lower mechanical strength, difference thermal characteristics, and introduction of contaminants.

It is therefore an object of the invention to provide a technique for heating and/or temperature-controlling a vapor-delivery line which eliminates the need for electrically isolated couplings in the delivery line.

In accordance with this and other objects of the invention, a supply line for heating a fluid is provided which includes a pair of spaced-apart, electrically-conductive fluid line segments. The first of these fluid line segments has a first inlet end and a second outlet end. The second fluid line segment has a first inlet end and a second outlet end. Fluid coupling means are provided for providing a fluid connection between the second outlet end of the first fluid line segment and the first inlet end of the second fluid line segment. An electrical connection is provided for electrically connecting the second end of the first fluid line segment with the first end of the second fluid line segment. Similarly, an electrical connection is provided for electrically connecting the first end of the first fluid line segment with the second end of the second fluid line segment. An electrical voltage is applied between the first and second electrical connections to cause an electrical current to flow through the first and second fluid line segments and to thereby heat a fluid flowing through these fluid line segments.

In one embodiment of the invention the fluid heated is a chemical vapor.

A transformer, having one terminal of a secondary winding connected to said first electrical connector means and another terminal of the secondary winding connected to said second electrical connector means, is provided for applying power.

The method of heating a fluid in a supply line includes coupling a fluid to be heated through a pair of spaced-apart, electrically-conductive fluid line segments. The line segments include a first fluid line segment having a first inlet end and a second outlet end. A second fluid line segment has a first inlet end and a second outlet end. The method intrudes the step of coupling the fluid between the second outlet end of the first fluid line segment and the first inlet end of the second fluid line segment. The second end of the first fluid line segment is electrically connected to the first end of the second fluid line segment. The first end of the first fluid line segment is electrically connected to the second end of the second fluid line segment. The next step is to apply an electrical voltage between the first and second electrical connections to cause an electrical current to flow through the first and second fluid line segments and to thereby heat the fluid flowing through these fluid line segments.

The accompanying drawings, which are incorporated in and form a part of this specification, illustrate embodiments of the invention and, together with the description, serve to explain the principles of the invention:

Figure 1 is a plan view of a U-shaped heater line according to the invention.

Figure 2 is an elevation view of the U-shaped heater line of Figure 1.

Figure 3 is a partially sectional view of a wrapped, insulated U-shaped heater line.

Figure 4 is a schematic diagram of the electrical components used with a U-shaped heater line according to the invention.

Figure 5 shows a prior art arrangement for heating a single line, which requires an electrical isolation coupling.

Reference will now be made in detail to the preferred embodiments of the invention, examples of which are illustrated in the accompanying drawings. While the invention will be described in conjunction with the preferred embodiments, it will be understood that they are not intended to limit the invention to those embodiments. On the contrary, the invention is intended to cover alternatives, modifications and equivalents, which may be included within the spirit and scope of the invention as defined by the appended claims.

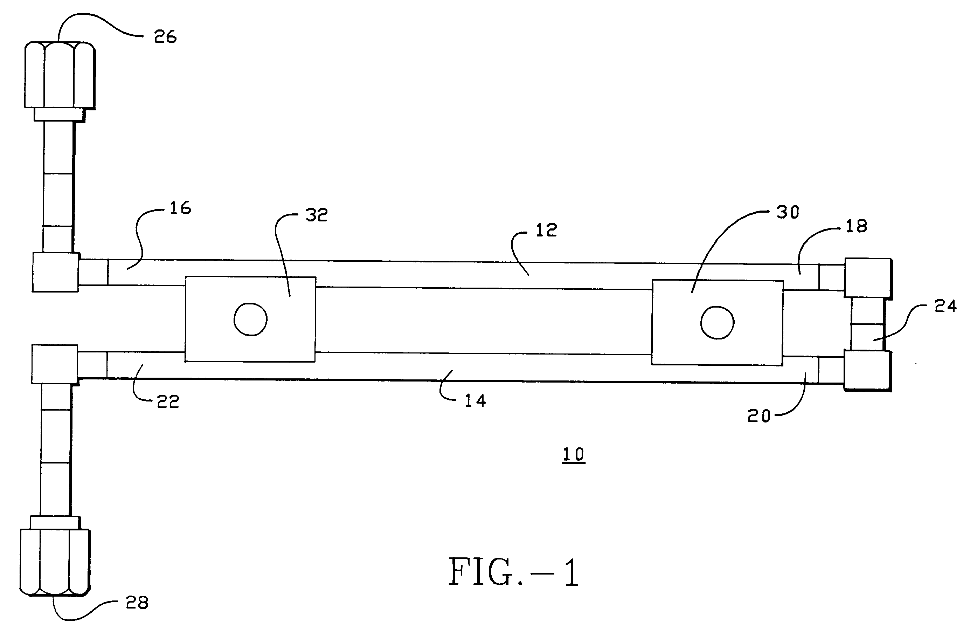

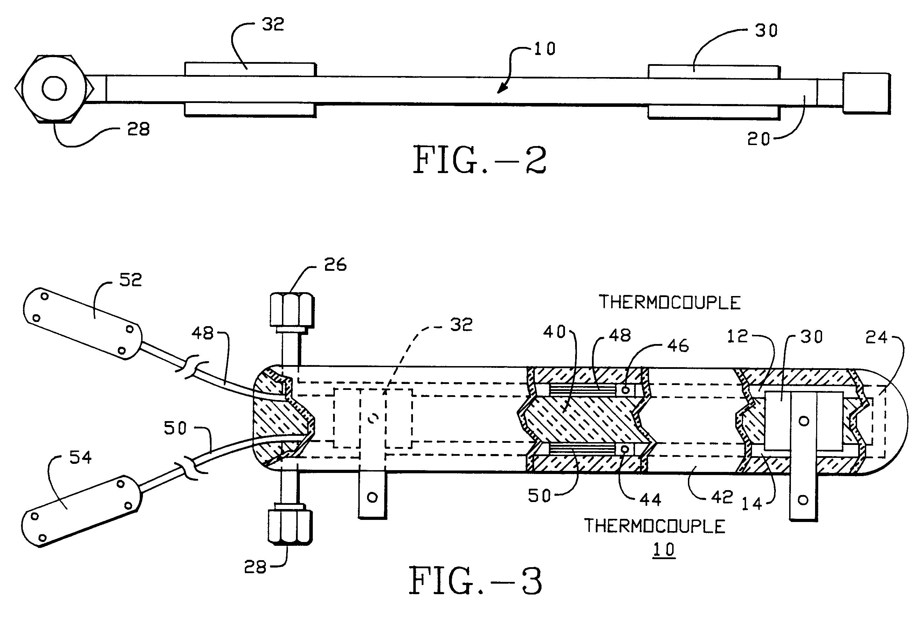

Figure 1 is a plan view and Figure 2 is a side view of a U-shaped heater line assembly 10, which functions, for example, as a supply line for heating a fluid, such as a chemical vapor used for processing and fabricating semiconductor wafers. The assembly includes a pair of parallel, spaced-apart, electrically-conductive fluid line segments 12,14, formed of stainless steel tubing. The first fluid line segment 12 has a first inlet end 16 and a second outlet end 18, as shown in the Figure. The second fluid line segment 14 has a first inlet end 20 and a second outlet end 22. Fluid coupling between the second outlet end 18 of the first fluid line segment 12 and the first inlet end 20 of the second fluid line segment 14 is provided by a small stainless steel U-section 24, welded to the respective ends of the fluid line segments. The first inlet end 16 of the first fluid line segment 12 is coupled to a fluid inlet source using a coupling 26. The second outlet end 22 of the second fluid line segment 14 is coupled to a downstream fluid utilization device using another coupling 28, as shown.

An electrical connection to one end of the U-shaped heater line assembly 10 is provided by a first electrical connector block 30 which is a conductive block welded to electrically connect the second end 18 of the first fluid line segment 12 to the first end 20 of the second fluid line segment 14. An electrical connection to the other end of the U-shaped heater line assembly 10 is provided by a second electrical connector block 32 which is a conductive block welded to electrically connect the second end 18 of the first fluid line segment 12 to the first end 20 of the second fluid line segment 14. An electrical voltage is applied between the first and said second electrical connector block 30,32 to cause an electrical current to flow through the first and second stainless steel fluid line segments 12, 14 to heat the segments and, consequently, the fluid flowing through those line segments.

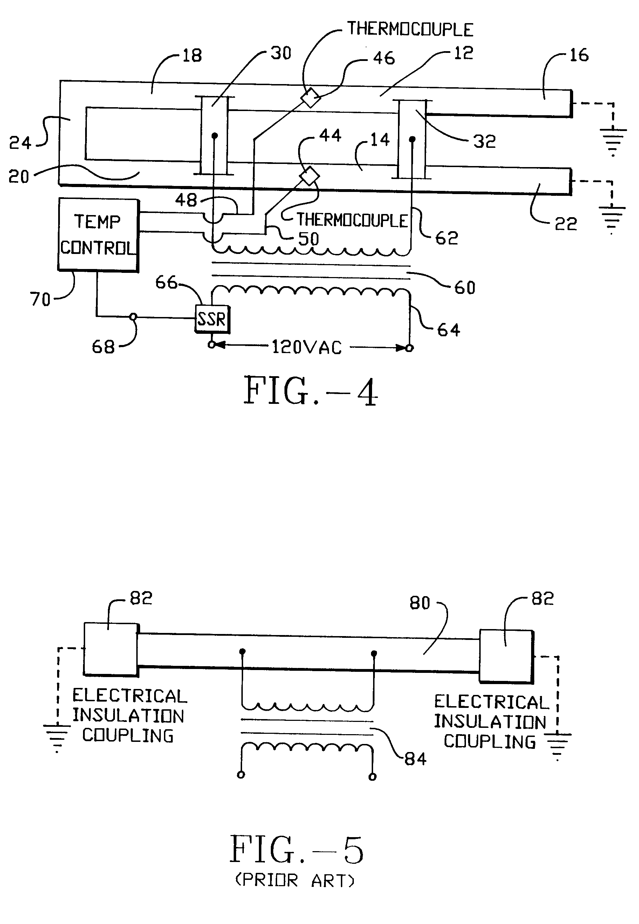

Figure 3 shows an insulated U-shaped heater line 10 which includes insulating material 40, which is positioned between the electrical connector blocks 30,32 and which is wrapped with several layers of an insulating tape 42. Thermocouple temperature sensors 44,46 are fixed to the line segments 12,14. as indicated. Respective lead wires 48,50 for the thermocouples terminate in connectors 52,54.

Figure 4 is a schematic diagram of additional electrical components used with a U-shaped heater line assembly 10 for providing low voltage (1-2 volts), high current (60100 amps) electrical power to the connector blocks 30,32 for heating the stainless steel fluid line segments 12, 14. Power is provided to the heater line through a step-down transformer 60 which has the terminals of the low-voltage secondary winding 62 connected the connector blocks 30,32. The primary winding 64 of the step-down transformer receives power from a 120 VAC power line through a series regulator circuit 66 which, for example, is solid state relay SSR circuit. A control terminal 68 for the series regulator circuit 66 is provided with a control signal from a temperature control circuit 70. The thermocouple temperature sensors 44,46 provide input signals to the control circuit 70, which control the amount of electrical power applied to heat the fluid line segments 12,14.

The U-shape of the heater line eliminates the need to isolate the heater line segments 12,14 from ground potential, as indicated by the ground symbols shown at the respective ends 16,22 of the line segments.

Figure 5 shows a prior art arrangement for heating a single fluid line segment 80, which requires an electrical isolation coupling 82 to isolate the ground paths available at each end of the fluid line segment. This line segment is heated by having two spaced-apart electrical terminal connected to the delivery line and applying a suitable electrical current through the terminals and through the line using a stable transformer 84. At least one end of the line section must be electrically isolated from the main part of the delivery line to confine the electrical current to the line section being heated. This requires use of an isolation coupling 82 for the line section so that the line section is electrically isolated. Use of such isolation couplers results in problems, including breakage of glass or ceramic elements, lower mechanical strength, different thermal characteristics, and introduction of contaminants. Use of the invention as described hereinabove avoids these problems by eliminating the necessity for an isolation coupler.

Note that the invention is not of necessity strictly limited to a "U-shaped" heater line. A "U-shaped" arrangement is preferred in some applications. The invention basically requires a pair of spaced-apart, electrically-conductive fluid line segments along with a fluid coupling means for providing a fluid connection between the second outlet end of the first fluid line segment and the first inlet end of the second fluid line segment.

The foregoing descriptions of specific embodiment of the present invention have been presented for purposes of illustration and description. They are not intended to be exhaustive or to limit the invention to the precise forms disclosed, and obviously many modifications and variations are possible in light of the above teaching. The embodiments were chosen and described in order to best explain the principles of the invention and its practical application, to thereby enable others skilled in the art to best utilize the invention and various embodiments with various modifications as are suited to the particular use contemplated it is intended that the scope of the invention be defined by the Claims appended hereto and their equivalents.

## Claims

1. A supply line for heating a fluid, comprising:

   first and second electrically-conductive fluid line segments (12,14), said first fluid line segment spaced apart from said second fluid line segment, said first fluid line segment having a first inlet end (16) and a second outlet end (18), and said second fluid line segment having a first inlet end (20) and a second outlet end (22);

   electrically-conductive fluid coupling means (24) providing a fluid connection between the second outlet end of the first fluid line segment and the first inlet end of the second fluid line segment, said fluid coupling means including a coupling fluid line segment having a first inlet end connected to the second end of said first fluid line segment and having a second outlet end connected to the first end of said second fluid line segment;

   first electrical connector means (30) for electrically connecting the second end of said first fluid line segment with the first end of said second fluid line segment;

   second electrical connector means (32) for electrically connecting the first end of said first fluid line segment with the second end of said second fluid line segment;

   means for applying an electrical voltage between said first and said second electrical connector means to cause an electrical current to flow through said first and said second fluid line segments and to thereby heat a fluid flowing through said first and said second fluid line segments.

2. A supply line as claimed in claim 1 wherein said first and said second fluid line segments are formed of stainless steel tubing.

3. A supply line as claimed in any preceding claim wherein said first and second second fluid line segments and said coupling fluid line segment are connected by being welded together.

4. A supply line as claimed in any preceding claim wherein said fluid is a chemical vapor.

5. A supply line as claimed in any preceding claim wherein said fluid coupling means includes a third fluid line segment connecting said first and said second fluid line segments.

6. A supply line as claimed in any preceding claim wherein said means for applying an electrical voltage includes a transformer having one terminal of a secondary winding connected to said first electrical connector means and another terminal of the secondary winding connected to said second electrical connector means.

7. A method of heating a fluid in a supply line, comprising the steps of:

   coupling a fluid to be heated through first and second spaced-apart, electrically-conductive fluid line segments (12,14), said first fluid line segment (12) having a first inlet end (16) and a second outlet end (18), and said second fluid line segment having a first inlet end (20) and a second outlet end (22);

   coupling said fluid between the second outlet end of said first fluid line segment and the first end of said second fluid line segment through an electrically conductive coupling fluid line segment (24) having a first inlet end connected to the second end of said first fluid line segment and having a second outlet end connected to the first end of said second fluid line segment;

   electrically connecting the second end of said first fluid line segment with the first end of said second fluid line segment;

   electrically connecting the first end of said first fluid line segment with the second end of said second fluid line segment;

   applying an electrical voltage between said first and said second electrical connector means to cause an electrical current to flow through said first and said second fluid line segments and to thereby heat the fluid flowing through said first and said second fluid line segments.

8. A method as claimed in claim 7 wherein said fluid is a chemical vapor.

9. A method as claimed in claim 7 wherein the step of applying an electrical voltage includes applying said electrical voltage using a transformer having a secondary winding with its ends connected to supply current to said fluid line segments.

FIG. — 1

EP 0 482 877 A1

32

10

30

28

20

## FIG.-2

52

26

48

THERMOCOUPLE

32

40    48    46    12    30    24

28

50    44    42    14

50

54

THERMOCOUPLE

10

## FIG.-3

THERMOCOUPLE

FIG.−4

FIG.−5
(PRIOR ART)

European Patent
Office

**EUROPEAN SEARCH REPORT**

Application Number

EP    91 30 9735

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | GB-A-1 168 770 (TEXAS INSTRUMENTS INCORPORATED) | 1,5,7 | C23C16/44 |
| Y | * claim 1; figure 1 * | 2-4,6,8, 9 | F24H3/04 |
| | --- | | |
| Y | GB-A-609 391 (J.W. TILLS) <br> * page 2, line 79 - line 101; figure 2 * | 2,6,9 | |
| | --- | | |
| Y | JOURNAL OF THE ELECTROCHEMICAL SOCIETY <br> vol. 136, no. 9, 1 September 1989, MANCHESTER, NH, USA <br> pages 2749 - 2751; <br> D.N.BUCKLEY ET AL.: 'an investigation of sodium alumina silicate molecular sieves for the pretreatment of arsine used in a hydride vpe reactor' <br> * page 2750, column 1, line 7 - line 12; figure 1 * | 3,4,8 | |
| | ----- | | TECHNICAL FIELDS SEARCHED (Int. Cl.5 ) <br><br> C23C <br> F24H |

The present search report has been drawn up for all claims

| Place of search | Date of completion of the search | Examiner |
|---|---|---|
| THE HAGUE | 16 JANUARY 1992 | EKHULT H.U. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)